Europäisches Patentamt

European Patent Office

Office européen des brevets

(19)

(11) Veröffentlichungsnummer: **0 032 709**
**B1**

(12) **EUROPÄISCHE PATENTSCHRIFT**

(45) Veröffentlichungstag der Patentschrift:
**03.10.84**

(21) Anmeldenummer: **81100187.4**

(22) Anmeldetag: **13.01.81**

(51) Int. Cl.³: **C 23 C 15/00**, G 01 N 27/56,
B 26 B 21/60

(54) Vorrichtung zur (Teil)Beschichtung eines Substrates durch Kathodenzerstäubung, Verfahren zur Beschichtung und deren Anwendung.

(30) Priorität: **22.01.80 DE 3002194**

(43) Veröffentlichungstag der Anmeldung:
**29.07.81 Patentblatt 81/30**

(45) Bekanntmachung des Hinweises auf die Patenterteilung:
**03.10.84 Patentblatt 84/40**

(84) Benannte Vertragsstaaten:
**AT CH FR GB IT LI SE**

(56) Entgegenhaltungen:
**EP - A - 0 007 805**
**FR - A - 2 314 265**
**US - A - 3 764 511**
**US - A - 3 846 294**
**US - A - 4 097 636**

(73) Patentinhaber: **Berna AG Olten, Industriestrasse 36,
CH-4600 Olten (CH)**

(72) Erfinder: **Rordorf, Horst, Ifangstrasse 17,
CH-8104 Weiningen (CH)**

(74) Vertreter: **Hansen, Bernd, Dr.rer.nat. et al, Hoffmann,
Eitle & Partner Patentanwälte Arabellastrasse 4,
D-8000 München 81 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

### Beschreibung

Die Erfindung betrifft eine Vorrichtung zur (Teil)-Beschichtung eines Substrates bzw. einer Mehrzahl hiervon durch Kathodenzerstäubung mit einer Kathode, Anode in einem Rezipienten, Gaszumisch- und -abführeinrichtungen, sowie einer Vakuumerzeugungsanlage. Die Erfindung betrifft weiter ein Verfahren zur Beschichtung einer (Mehr)-Zahl von Substraten sowie die Anwendung von Vorrichtung und Verfahren.

Die Methodik der Kathodenzerstäubung im Vakuum erlaubt die Aufbringung von Metallen und Derivaten hiervon mit hohem Schmelzpunkt in einfacher Weise mit ausgezeichneter Haftfestigkeit auf Substraten verschiedener Art. Mit Hilfe der reaktiven Kathodenzerstäubung können Oxide, Nitride und Karbide verschiedenartiger Metalle niedergeschlagen werden.

Betreibt man eine Glimmentladung im anormalen Kathodenfall, so spielen sich in der elektrischen Entladung verschiedene Vorgänge ab. Die Gasatmosphäre zwischen den Elektroden wird durch die angelegte Spannung ionisiert. Die auftretenden Ionen, die nahezu ausschliesslich Kationen darstellen, bewegen sich unter dem Einfluss des elektrischen Feldes gegen die Kathode und prallen dort mit hoher Energie auf. Die durch den Ionenaufprall auf der Oberfläche freiwerdende Energie hat einerseits eine Emission von Elektronen, die zur Aufrechterhaltung der Gasentladung beitragen, wie anderseits von ungeladenen Metallatomen bzw. -molekülen zur Folge. Infolge des Zerstäubungseffektes der Kathodenoberfläche durch auftreffende Ionen besteht die Entladungszone vor der Kathode aus einem Gemisch von Trägergas, gegebenenfalls Reaktivgas, und Metallatomen der Kathode. Aufgrund der ungeladenen Natur des Metalldampfes ist dieser dem elektrischen Feldverlauf nicht unterworfen und kann daher zur Kondensation auf metallischen oder nichtmetallischen Substraten gebracht werden. Zwar wird diese Art der Metallübertragung im Vakuum bereits seit längerer Zeit im Rahmen verschiedenartiger Kathodenzerstäubungsverfahren industriell, z.B. zur Herstellung von Spiegeln, genutzt, gleichwohl ist dieser Technik eine Durchsetzung gegenüber der chemischen Abscheidungstechnik (sogenannte CVD-Technik) noch nicht gelungen. Dies lässt sich unter anderem auch darauf zurückführen, dass bei einem Aufstäubungsprozess die aus der Kathode freigemachten Metallatome nur zu einem geringen Prozentsatz das zu bestäubende Substrat erreichen. Der überwiegende Anteil der abgestäubten Metallatome kehrt aufgrund von Stoss mit Gasatomen wieder auf die Metalloberfläche zurück. Dieser Rückwanderungsanteil ist somit auch druckabhängig. Andere Schwierigkeiten ergaben sich aus starken Erhitzungen der Kathode sowie zum Teil durch die, durch die Geometrie der apparativen Bestäubungsvorrichtungen bedingten, niedrigen Zerstäubungsausbeuten.

In den konventionellen Kathodenzerstäubungsanlagen liegen die Substrate häufig unmittelbar auf der Anode auf, wie dies z.B. in Electronic Packaging and Production, Dezember 1978, Seiten 461–463, beschrieben ist. Dadurch sind die Substrate dem Sekundärelektronenbeschuss voll ausgesetzt, wodurch sich sehr hohe Substrattemperaturen im Bereich bis zu ca. 500°C, je nach Aufstäubrate, Aufstäubzeit, Druck der Träger- und Reaktivgase usw., ergeben. Eine Verbesserung wurde durch eine Magnetfeldunterstützung erreicht, durch die das Plasma mittels eines Magnetfeldes unmittelbar vor der Kathode konzentriert wird.

Bei anderen bekannten Vorrichtungen, wie sie beispielsweise in «Schweizer Maschinenmarkt», Nr. 8/1972, Seiten 73, 74, beschrieben worden sind, befinden sich die Substrate auf Werkstoffhalterungen in der Nähe der Kathode bzw. die Substrate sind auf einem sich drehenden Werkstoffhalter in der Mitte einer hohlzylinderartig ausgebildeten Kathode, die in Sektoren unterteilt sein kann, angeordnet.

Die herkömmlichen Vorrichtungen vermögen im Hinblick auf die erreichbaren Ausbeuten, die Einfachheit des Betriebes usw., noch nicht vollkommen zu befriedigen. Der Erfindung liegt daher die Aufgabe zugrunde, eine verbesserte Vorrichtung zur Beschichtung eines Substrates und vorzugsweise einer Vielzahl von Substraten durch Kathodenzerstäubung im anormalen Kathodenfall zu schaffen, bei der sich hohe Bestäubungsausbeuten bei gleichzeitig niedrigen Reaktionszeiten erreichen lassen. Insbesondere soll die Vorrichtung auch die Teilbeschichtung der Substrate gestatten. Anderseits soll sich durch die Vorrichtung die Abscheidung hochreiner Niederschläge auch bei der reaktiven Kathodenzerstäubung erreichen lassen. Nach einem Aspekt dieser Aufgabe ist die Erfindung auch auf ein Beschichtungsverfahren unter Anwendung der Vorrichtung gerichtet. Insbesondere soll sich unter Anwendung der Vorrichtung und des Verfahrens eine besonders günstige Teilbeschichtung von Messsonden, z.B. solchen, die als Messvorrichtungen zur Überwachung von Gasgemischen in Verbrennungsmotoren, eingesetzt werden, mit geeigneten Überzügen, z.B. aus Edelmetallen, erreichen lassen.

Diese Aufgabe wird durch die Schaffung einer Vorrichtung der eingangs genannten Art gelöst, die dadurch gekennzeichnet ist, dass das bzw. die Substrat(e) in die Kathode zu dieser isolierend derart eingebaut ist bzw. sind, dass der zu beschichtende Teil des Substrates sich über die Kathodenoberfläche in den Bereich des Plasmas der Glimmentladung erstreckt.

Durch den Einbau des Substrates in die Kathode selbst wird eine Reihe von Vorteilen erzielt. Durch die unmittelbare Nachbarschaft der Kathodenoberfläche zu dem Substrat kann in einem relativ hohen Druckbereich und daher bei hoher Leistung und günstiger Ausbeute gearbeitet werden. Der Rückwanderungsanteil der abgestäubten Metallatome wird im übrigen optimal ausgenutzt. Durch den Teileinbau des bzw. der Substrate in die Kathodenoberfläche kann sichergestellt werden, dass nur der über die Oberfläche hinausragende Anteil des Substrates eine Beschichtung erfährt. Dadurch eignet sich die erfindungsgemässe Vorrichtung insbesondere für die Teilbeschichtung von Substraten mittels der Kathodenzerstäubung durch Glimmentladung im anormalen Kathodenfall. Da die Substrate, auch dann, wenn sie selbst Isolatoren darstellen, wie z.B. Substrate aus Keramik, Glas usw., durch die aufgestäubte Metallbeschichtung im Verlauf des Zerstäubungsverfahrens selbst zu Leitern werden, ist es wichtig, die Substrate gegenüber der Kathode zu isolieren. Hierbei sind in der erfindungsgemässen Vorrichtung insbesondere Schutzspalten vorgesehen, die in ihrer Form in Abhängigkeit von der Haltevorrichtung des Substrates bzw. dem Substrat selbst variiert sein können. So können die Schutzspalten ring- oder trichterförmig ausgebildet sein, Diskontinuitäten aufweisen und es kann z.B. auch vor dem Spalt eine Trennfuge vorgesehen sein.

Wenn mit der erfindungsgemässen Vorrichtung eine Mehrzahl von Substraten gleichzeitig beschichtet werden soll, ist es bevorzugt, dass die Kathode die Anode in symmetrischer Weise umgibt. Beispielsweise kann die Anode rotationssymmetrisch durch die Kathode, in der sich die Haltevorrichtungen in gleichmässiger Verteilung befinden können, umgeben sein. So kann nach einer bevorzugten Ausführungsform der erfindungsgemässen Vorrichtung die Kathode eine Zylinderform oder die Form eines Vieleckes aufweisen, die gegebenenfalls in Segmente unterteilt sein kann. Im Innenbereich einer solchen Hohlanordnung, zweckmässig in deren Zentrum, kann die Anode, die z.B. stabförmig ausgebildet sein kann, angeordnet werden. Durch eine derartige Ausbildungsform kann erreicht werden, dass sämtliche Haltevorrichtungen bzw. Aussparungen für die Aufnahme der Substrate in der Kathode in Richtung auf die Anode so ausgerichtet sind, dass sich für alle Substrate ein gleicher Anodenabstand und daher eine gleichmässige Beschichtungssituation ergibt.

Wenn die Kathode beispielsweise als Hohlzylinder mit glatter oder vieleckiger Innenfläche ausgebildet ist, kann die Aussenfläche der Kathode auf einfache Weise gekühlt werden, wodurch niedrige Substrattemperaturen erreichbar sind. Insbesondere kann an der Aussenoberfläche der Kathode eine Wasserkühlvorrichtung, beispielsweise als Kühlmantel, usw., vorgesehen sein.

Bei dem erfindungsgemässen Verfahren kann eine Mehrzahl von Substraten durch Kathodenzerstäubung mit Hilfe der Glimmentladung im anormalen Kathodenfall homogen in kurzer Zeit beschichtet werden. Hierbei wird insbesondere in einem Druckbereich von etwa 0,1 bis 5 Torr (13,33 bis 666,61 Pa) bei z.B. Spannungen im Bereich von etwa 300 bis 1000 V gearbeitet. Das erfindungsgemässe Verfahren lässt sich durch die spezielle Ausgestaltung der Vorrichtung bei relativ geringem Unterdruck, z.B. im Bereich von 1 bis 1,5 Torr (133,32 bis 199,98 Pa), durchführen. Die Vorrichtung und das erfindungsgemässe Verfahren haben ihre besondere Anwendung in der gleichzeitigen Beschichtung einer Mehrzahl von Substraten, bei denen auf eine homogene und gleichmässige Beschichtung Wert gelegt ist. Insbesondere kann sie zur Beschichtung von Messsonden dienen, z.B. von Keramiksonden zur Messung der Abgaszusammensetzung für die Kfz-Industrie. Solche Sonden sind bekannt und befinden sich derzeit in intensiver Erprobung. Hierbei handelt es sich um relativ klein dimensionierte Keramikkörper, die in Form eines spitz zulaufenden «Hutes» ausgebildet sein können.

Die Keramikkörper weisen an ihrem vorderen oberen Teil eine Porosität auf und müssen in gerade diesem Bereich teilbeschichtet werden. Im inneren Hohlraum der Sonde befindet sich im Regelfall ein bis zur unteren Bodenfläche durchlaufender Leiterstreifen. Durch die Anwendung der erfindungsgemässen Vorrichtung bzw. des Verfahrens unter deren Anwendung lassen sich derartige Keramiksonden sehr günstig mit Edelmetallen, wie Platin, Iridium, Palladium usw. teilbeschichten. Es ist aber nicht nur die Beschichtung mit metallischen Substraten, unter denen derzeit Platin bevorzugt ist, möglich, sondern es können auch Derivate dieser oder anderer Metalle durch die gleichzeitige Anwesenheit reaktiver Gase, z.B. Karbide, Nitride und Oxide, zum Niederschlag kommen. Es hat sich gezeigt, dass durch den Einbau der Sonden in einer bevorzugten Ausführungsform der erfindungsgemässen Vorrichtung, die nachstehend schematisch dargestellt ist, sich eine sehr günstige, hochreine und auch homogene Beschichtung der Sonde in ihrem oberen Bereich, wie dies gewünscht wurde, erreichen lässt. Derartige Sonden für die Messung der Zusammensetzung des Abgases bei Kraftfahrzeugen, die vor der Einführung in die Produktion stehen, werden nach derzeitigen Versuchen durch CVD-Beschichtung im Vakuum, ausgehend von Platinacetonylacetonat bzw. durch die physikalische Aufdampfung von Platin aus einer Platinschmelze, beschichtet. Bei diesen Beschichtungsverfahren ergeben sich unzureichende Ausbeuten, während bei der physikalischen Platinaufdampfung noch ein erheblicher Energieaufwand erforderlich ist. Demgegenüber werden durch die erfindungsgemässe Methodik bei geringen Beschichtungszeiten hohe Beschichtungsausbeuten bei vernünftigem Energieaufwand erzielt.

Bevorzugte Ausführungsformen der erfindungsgemässen Vorrichtung sind in den beigefügten Figuren schematisch dargestellt.

Fig. 1 zeigt die isolierende Lagerung eines Substrates, hier eine Sonde, in der Kathode;

Fig. 2 zeigt einen Querschnitt durch die Elektrodenanordnung, in der die Substrate gelagert sind.

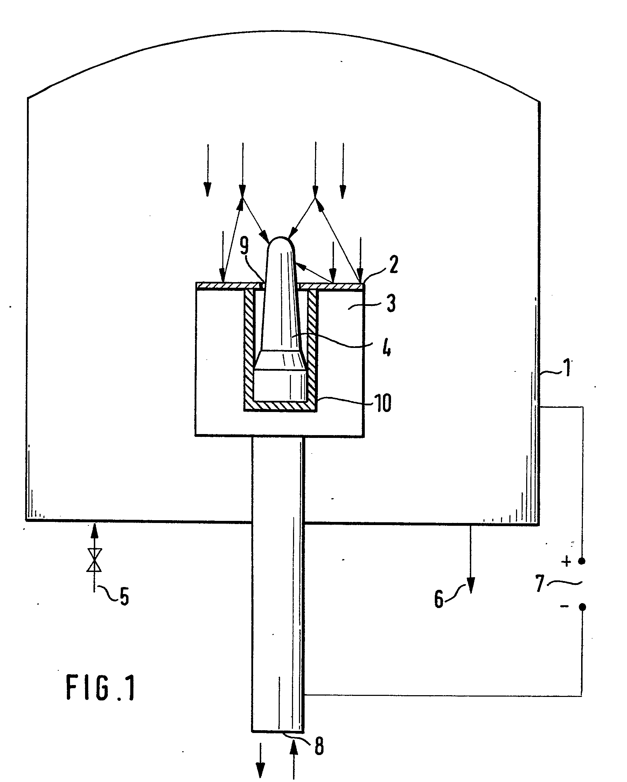

In Fig. 1 bedeutet 1 die Anode (und Rezipient), zu der die Kathode 3 mit ihrer als Target wirkenden Oberfläche 2 angeordnet ist. In der Kathode ist die das Substrat hier abgebende Sonde durch eine Keramikisolierung 10 und einen Ringspalt 9 isolierend gelagert. In den Glimmentladungsraum wird über den Gaseinlass 5 Trägergas, im Regelfall Argon, eingelassen und über die Pumpe 6 – je nach gewünschtem Druckverhältnis – gegebenenfalls abgezogen. Die im unteren Teil der Schemazeichnung angegebenen Pfeile bezeichnen eine Wasserkühlung 8 des Kathodenteils bzw. gegebenenfalls des hierin gelagerten Substratteils. Aus der Schemazeichnung ist ersichtlich, dass lediglich der obere Spitz der Messsonde eine Beschichtung durch Kathodenzerstäubung erfahren kann.

In dieser schematisch gezeigten Vorrichtung kann z.B. eine Teilbeschichtung des Sondenspitzes mit Platin erfolgen, wenn die Kathodenoberfläche als Pt-Target ausgebildet ist. Sind Beschichtungen mit anderen Metallen bzw. -derivaten, z.B. Platinmetalloxiden, gewünscht, können zusätzlich reaktive Gase, wie Sauerstoff, Stickstoff oder C-liefernde Komponenten, eingeführt werden.

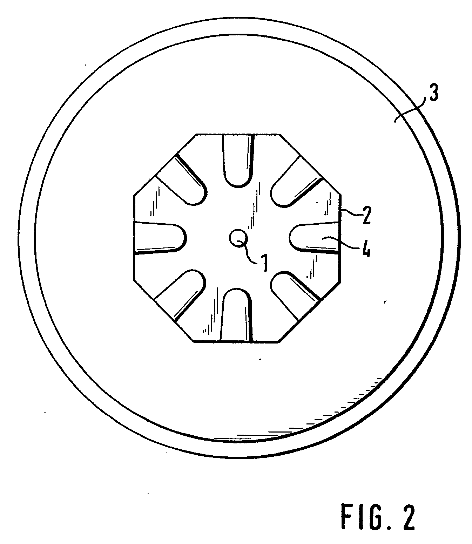

In Fig. 2 ist die Anordnung einer Mehrzahl von Sonden 4 innerhalb einer als Vieleck ausgebildeten Kathode 3 gezeigt, deren Oberfläche 2 als Target, z.B. Pt-Target, wirkt. Im Inneren des Hohlraums der Kathode befindet sich eine stabförmige Anode 1, zu der die Sonden mit gleichem Abstand symmetrisch angeordnet sind. Haltevorrichtungen für die Substrate, mit denen diese gegebenenfalls auch in Rotation versetzt werden können, sind in der Schemazeichnung, genau wie Drehvorrichtungen für die Kathode insgesamt, wie auch die Hilfsvorrichtungen, wie Gaszuflüsse und -abflüsse, Rezipient usw., weggelassen. Bei dieser gezeigten Ausführungsform der erfindungsgemässen Vorrichtung wird die stabförmige Anode aus der in Form eines Hohlzylinders ausgebildeten Kathode in an sich bekannter Weise an deren Ober- bzw. Unterteil isolierend ausgeführt.

Der Ablauf des erfindungsgemässen Verfahrens soll unter Bezugnahme auf die Fig. 1 und 2 noch weiter erläutert werden. Wie aus Fig. 1 zu entnehmen ist, ist der bei den Sonden zu beschichtende Spitz derart in die Kathodenoberfläche eingebaut, dass nur der zu bestäubende Teil der Sonde dem Plasma der Glimmentladung ausgesetzt ist. Die aufgestäubte Masse ist elektrisch von der Kathode getrennt und wird nur von negativem Glimmlicht umspült. Wählt man nun einen geeigneten Druckbereich, so kann die aufgestäubte Masse dem Glimmlicht Ladungsträger entziehen und selbst als Kathode mit geringer Leistung gegenüber der Anode brennen. Das hat zur Folge, dass die aufgestäubten Atome mit wenig Bindungsenergie wieder abgestäubt werden, wodurch eine gleichmässigere fehlerfreie Schicht entsteht. Ferner wird bei dieser Anordnung der Sonde der Rückwanderungsanteil der abgestäubten Metallatome besser genutzt. Durch die unmittelbare Nähe der Kathode zu dem Substrat kann in einem relativ hohen Druckbereich gearbeitet werden, z.B. im Bereich von 1 bis 2 Torr (133,32 bis 266,64 Pa). Dadurch können die Leistung und somit die Ausbeute erhöht werden.

Aus Fig. 2 ergibt sich, dass die Vorrichtung zum serienmässigen Beschichten von Abgassonden mit beispielsweise Platin mit den in Längsstreifen eingebauten Sonden in Form eines Vielecks ein geschlossenes System ergibt. Der Vorteil dieser Anordnung besteht darin, dass hierbei der grösste Anteil an freigemachten Metallatomen aus der Kathodenoberfläche, die nicht auf einem Substrat zur Kondensation gelangt sind, wieder am Abstäubungsprozess teilnehmen. Dies erfolgt dadurch, dass die nicht auf einem Substrat zur Kondensation gelangten Metallatome auf den Begrenzungsflächen, die wiederum eine Kathode darstellen, kondensieren. Will man bei dieser Anordnung zu hohen Stromdichten gelangen, kann man bei diesen gegebenen geometrischen Verhältnissen auch den sogenannten «Hohlentladungseffekt» anwenden.

Die erfindungsgemässe Vorrichtung ist zur Beschichtung einer Vielzahl von Substraten geeignet, wobei als derzeit bevorzugte Anwendung die Beschichtung von Messfühlern bzw. Messsonden, z.B. aus poröser Keramik, angegeben worden ist. Die Erfindung lässt sich aber in gleicher Weise auf die Beschichtung anderer Substrate, z.B. von Rasierklingen, kleinen Spiegeln usw., anwenden.

Die erfindungsgemässe Vorrichtung kann mit Vorteil für die Beschichtung von Substraten angewandt werden, wobei die Beschichtung unabhängig davon vorgenommen werden kann, ob die Substrate elektrisch leitend und elektrisch nichtleitend sind. Aus den vorigen Darlegungen ergibt sich weiter, dass es zum Betrieb der erfindungsgemässen Vorrichtung nicht notwendig ist, den Abscheidungsprozess durch Magnetfelder zu steuern. Auch ist es im Rahmen der Erfindung nicht notwendig, hochfrequente elektromagnetische Felder anzulegen. Vielmehr wird die erfindungsgemässe Vorrichtung bzw. das Verfahren zur Beschichtung von Substraten mit Gleichstrom betrieben.

**Patentansprüche**

1. Vorrichtung zur (Teil)Beschichtung eines Substrates bzw. einer Mehrzahl hiervon durch Kathodenzerstäubung mit einer Kathode, Anode in einem Rezipienten, Gaszumisch- und -abführeinrichtungen, sowie einer Vakuumerzeugungsanlage, dadurch gekennzeichnet, dass das bzw. die Substrat(e) in die Kathode zu dieser isolierend derart eingebaut ist bzw. sind, dass der zu beschichtende Teil des Substrats sich über die Kathodenoberfläche in den Bereich des Plasmas der Glimmentladung erstreckt.

2. Vorrichtung nach Anspruch 1, dadurch gekennzeichnet, dass die Kathode die Anode symmetrisch umgibt.

3. Vorrichtung nach Anspruch 1, dadurch gekennzeichnet, dass die Haltevorrichtungen bzw. Aussparungen zur Aufnahme der Substrate in der Kathode in gleicher Weise in Richtung auf die Anode derart ausgebildet sind, dass sich für alle Substrate ein gleicher Abstand zur Anode ergibt.

4. Vorrichtung nach Ansprüchen 1, 2 oder 3, dadurch gekennzeichnet, dass die Kathode an ihrer Rückfläche mit einer Kühlvorrichtung versehen ist.

5. Vorrichtung nach einem oder mehreren der vorhergehenden Ansprüche, dadurch gekennzeichnet, dass die Kathodenoberfläche die Innenfläche eines die Anode umgebenden Zylinders oder Vielecks darstellt.

6. Verfahren zur Beschichtung einer Mehrzahl von Substraten durch Kathodenzerstäubung unter Anwendung der Vorrichtung nach einem oder mehreren der vorhergehenden Ansprüche, dadurch gekennzeichnet, dass mittels einer Glimmentladung im anormalen Kathodenfall in einem Druckbereich von etwa 0,1 bis 5 Torr (13,33 bis 666,61 Pa) die Beschichtung bei ca. 300 bis 1000 V durchgeführt wird.

7. Anwendung von Vorrichtung und Verfahren nach einem oder mehreren der vorhergehenden Ansprüche, zur (Teil)Beschichtung von Keramiksonden mit Edelmetallen, wie Pt, Ir, Pd und deren durch die Anwesenheit reaktiver Gaser erzeugbaren Derivate.

8. Anwendung von Vorrichtung und Verfahren nach den Ansprüchen 1–6 zur Beschichtung von Rasierklingen.

## Claims

1. Device for the (partial) coating of a substrate or as the case may be of a plurality thereof by cathode sputtering having a cathode, anode in a container, gas admixing and abstracting devices, and a vacuum producing device, characterised in that the substrate or substrates is or are built into the cathode insulated from this in such manner that the part of the substrate to be coated extends over the cathode upper surface in the region of the plasma of the glow discharge.

2. Device according to claim 1 characterised in that the cathode surrounds the anode symmetrically.

3. Device according to claim 1 characterised in that the holder devices or openings for receiving the substrate in the cathode are constructed in the same manner in the direction of the anode so that for all substrates the same spacing from the anode results.

4. Device according to claims 1, 2 or 3 characterised in that the cathode is provided on its rear surface with a cooling device.

5. Device according to one or more of the preceding claims characterised in that the cathode upper surface represents the inner surface of a cylinder or polygon surrounding the anode.

6. Method for coating of a plurality of substrates by cathode sputtering with use of the device according to one or more of the preceding claims characterised in that by means of a glow discharge in the abnormal cathode fall in a pressure range from about 0.1 to 5 Torr (13.33 to 661.61 Pa) the coating is carried out at approximately 300 to 1000 V.

7. Use of the device and method according to one or more of the preceding claims for the (partial) coating of ceramic probes with noble metals such as platinum, iridium, palladium and the like and their derivatives produceable by the presence of reactive gases.

8. Use of the device and method according to claims 1 to 6 for the coating of razor blades.

## Revendications

1. Dispositif pour le revêtement (partiel) d'un substrat ou d'un certain nombre de ceux-ci par pulvérisation cathodique avec une cathode, une anode montée dans un récipient, des moyens d'addition et d'évacuation de gaz ainsi qu'une installation de production de vide, caractérisé par le fait que le ou les substrats est ou sont installé(s) dans la cathode de façon isolée par rapport à celle-ci et de manière que la partie du substrat à revêtir s'étende au-dessus de la surface de la cathode dans la zone du plasma de la décharge luminescente.

2. Dispositif selon la revendication 1, caractérisé par le fait que la cathode entoure symétriquement l'anode.

3. Dispositif selon la revendication 1, caractérisé par le fait que les dispositifs supports et les évidements servant de logements aux substrats dans la cathode sont réalisés de la même façon en direction de l'anode de façon qu'il en résulte pour tous les substrats une distance égale par rapport à l'anode.

4. Dispositif selon les revendications 1, 2 ou 3, caractérisé par le fait que la cathode est munie d'un dispositif de refroidissement sur sa face arrière.

5. Dispositif selon l'une ou plusieurs des revendications précédentes, caractérisé par le fait que la surface de la cathode représente la surface interne d'un cylindre ou d'un polygone entourant l'anode.

6. Procédé pour le revêtement d'un certain nombre de substrats par pulvérisation cathodique et utilisation du dispositif selon l'une ou plusieurs des revendications précédentes, caractérisé par le fait qu'au moyen d'une décharge luminescente en cas de chute cathodique anormale dans une zone de pression d'environ 0,1 à 5 torrs (13,33 à 666,61 Pa) on exécute le revêtement à environ 300 à 1000 V.

7. Utilisation du dispositif et du procédé selon l'une ou plusieurs des revendications précédentes, pour le revêtement (partiel) de sondes céramiques avec des métaux précieux, comme Pt, Ir, Pd et leurs dérivés pouvant être produits par la présence de gaz réactifs.

8. Utilisation du dispositif et du procédé selon les revendications 1–6 pour le revêtement de lames de rasoir.

FIG.1

FIG. 2